(19) Europäisches Patentamt
European Patent Office
Office européen des brevets

(11) **EP 2 023 490 A1**

(12) **EUROPEAN PATENT APPLICATION**

(43) Date of publication:
**11.02.2009 Bulletin 2009/07**

(51) Int Cl.:
***H03M 13/11*** *(2006.01)*

(21) Application number: **07014700.4**

(22) Date of filing: **26.07.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **ALi Corporation**
**Taipei City**
**Taiwan, R.O.C. (TW)**

(72) Inventors:
• **Liu, Lin**
**Taipei City**
**R.O.C. (TW)**

• **Chen, Yue-Yong**
**Taipei City**
**R.O.C. (TW)**

(74) Representative: **Hager, Thomas Johannes**
**Hoefer & Partner**
**Patentanwälte**
**Pilgersheimer Strasse 20**
**81543 München (DE)**

Remarks:
Amended claims in accordance with Rule 137(2) EPC.

(54) **Method and decoder for decoding low density parity check (LDPC) codes**

(57)  A method and a decoder (100) for decoding LD-PC codes are disclosed in the present invention. The present invention has advantages of reducing cost since the amount of the processing units (114) is not required be equal to the amount of the read messages in a word of the memory in the present invention decoder (100). In other words, the present invention decoder (100) and decoding method does not require a large amount of the processing units (114) while the conventional decoder and decoding method does, and therefore the present invention decoder (100) and decoding method is capable of attaining higher efficiency with lower cost.

Fig. 1

EP 2 023 490 A1

## Description

The present invention relates to methods and decoders for decoding LDPC codes according to the pre-characterizing clauses of claims 1 and 6.

In the modem information age binary values such as ones and zeros, are used to represent and communicate various types of information, for example, video, audio, statistical information, etc. Unfortunately, during storage, transmission, or processing of binary data, errors might be generated unintentionally. For example, a binary value "1" may be changed to another binary value "0" or vice versa. Generally, in the case of data transmission, a receiver observes each received bit in the presence of noise or distortion and only an indication of the bit value is obtained. Under these circumstances one interprets the observed values as a source of soft bits. A soft bit indicates a preferred estimate of the bit value, i.e. a binary value "1" or "0", together with some indication of that estimate's reliability. While the number of errors may be relatively low, even a small number of errors or level of distortion can result in the data being unusable or, in the case of transmission errors, may necessitate re-transmission of the data, degrading the data transmission efficiency greatly. Various types of coding schemes have been used over the years for error correction purposes. One class of codes generally referred to as low density parity check (LDPC) codes. The LDPC codes were actually invented by Gallager some 40 years ago (1961) but have only recently come to the fore. The LDPC codes are used in the context of so-called iterative coding systems, that is, the LDPC codes are decoded using iterative decoders. The LDPC decoding enables obtaining performances very close to the theoretical Shannon limit. LDPC decoders generally have better performances than turbo-code decoders and are currently, used in broadcasting systems, for example, satellite digital television broadcasting systems. The LDPC decoding consists, for a given word s containing k bits, of transmitting a word u containing n bits, among which n-k additional bits called parity bits which fulfill n-k parity equations. The matrix H having n-k rows and n columns verifying the following relation is called the code control matrix:

$$H*^{t}u=0$$

The size of the matrixes H generally used is significant since they may comprise more than 60,000 columns and 50,000 rows. Further, such matrixes are practically empty and may comprise one "1" for approximately 10,000 "0"s. This is why they are called low-density matrixes. The connection between the bit node and the check node are specified by the formula $\{x + (m \bmod 360)*q\} \bmod (n_{ldpc} - k_{ldpc})$ according to the specification defined by the European Telecommunications Standards Institute (ETSI) DVB-S2. According to this matrix it is most efficient to use 360 processing units running in parallel and the messages can be stored in a memory in a manner that 360 messages can be read simultaneously. However, because the bit nodes are connected sequentially while the check node is connected every q check nodes, sequentially 360 bit nodes are processed simultaneously while 360 check nodes of every q check nodes are processed simultaneously. In order to save memory, the message from a bit node to a check node share memory with the message from the same check node to the same bit node. They can share memory because one kind of the messages is utilized by the processing units to generate the other kind of the messages and each kind of the messages is discarded after it is utilized by the processing units. The connection from bit nodes to check nodes is also decided by a offset x which is different for every 360 bit nodes set, and therefore the 360 messages should be shuffled before or after processed by the processing units. Because of these characteristics of the DVB-S2 LDPC matrix, it is difficult to design a decoder for this LDPC code with a total number of processing units other than 360.

U.S. Patent Application Publication 20050283703A1 discloses an iterative LDPC decoding method, comprising a determined number of processing units operating in parallel, and in which an iteration comprises the steps of: a) reading first words from a storage means, each first word containing a juxtaposition of messages of a first type in a number equal to the determined number; b) providing each processing unit, for each first read word, with a message of the first type at a position in the first word which depends on the processing unit; c) having each processing unit successively provide messages of a second type based on a first processing of the messages of the first type; d) storing in the storage means second words, each second word corresponding to a juxtaposition of messages of the second type in a number equal to the determined number and each provided by a different processing unit, each message of the second type being at a position in the second word which depends on the associated processing unit; e) reading the second words from the storage means; f) providing each processing unit, for each second read word, with a message of the second type at a position in the second word which depends on the processing unit; g) having each processing unit successively provide new messages of the first type based on a second processing of the messages of the second type, the second processing being different from the first processing; h) storing in the storage means new first words, each new first word corresponding to a juxtaposition of messages of the first type in a number equal to a determined number and each provided by a different processing unit, each message of the first type being at a position in the new first word which depends on the associated processing unit, wherein, at step b), the position of the message of the first type in the first word further depends on the first word and, at step f), the position of the message of the second type in the second word further depends on the second word, or wherein, at step d), each message of the second type is at a position in the second word which depends on the second word and, at step h), each message of the first type is at a position in the new first word which depends on the new first word. Therefore, the determined number of the processing units is required to be equal to the numbers of the messages in the first words and the second words. In addition, U.S. Patent Application Publication 20040005865A1 discloses a LDPC decoder for a LDPC matrix which ensures that the relevant edges for a group of bit nodes and check nodes are simultaneously placed together in RAM (page 7, paragraph [0091]), and 392 bit nodes and 392 check nodes are selected for processing at a time in one example (page 7, paragraph [0093]). Thus, the amount of the processing units is also required to be equal to the amount of the messages in a word of the memory. However, the conventional LDPC decoding method requiring a large amount of the processing units costs a lot. Therefore, the conventional LDPC decoding method costs a lot, and a new LDPC decoding method for reducing the cost is required.

This in mind, the present invention aims at providing methods and decoders for decoding low density parity check (LDPC) codes that require less processing units and have higher efficiency with lower cost.

This is achieved by methods and decoders for decoding LDPC codes according to the independent claims 1 and 6. The respective dependent claims pertain to corresponding further developments and improvements.

As will be seen more clearly from the detailed description following below, one claimed method for decoding LDPC codes includes steps of: (a) repeatedly reading a plurality of first type messages and feeding a part of the plurality of read first type messages to a predetermined amount of first type processing units, until all of the first type messages of a codeword have been processed by the first type processing units, wherein the predetermined amount of the first type processing units is less than amount of the plurality of read first type messages; (b) repeatedly reading a plurality of second type messages and feeding a part of the plurality of read second type messages to a predetermined amount of second type processing units, until all of the second type messages of the codeword have been processed by the second type processing units, wherein the predetermined amount of the second type processing units is less than amount of the plurality of read second type messages; (c) updating an iteration counter value; and (d) if the iteration counter value reaches a first predetermined value, then generating a decision result and outputting it as a decoding result of the codeword; otherwise, repeating steps (a), (b), (c), and (d).

As will be seen more clearly from the detailed description following below, one claimed decoder for decoding LDPC codes includes a processing module, an access controlling module, a first memory unit, a second memory unit, and a counter module. The processing module includes a predetermined amount of first type processing units and a predetermined amount of second type processing units, and the processing module is utilized for processing a plurality of first type messages and a plurality of second type messages and generating a decision result, wherein the decision result has a plurality of decision bits. The access controlling module is coupled to the processing module and utilized for repeatedly reading a plurality of first type messages and feeding a part of the plurality of read first type messages to a predetermined amount of first type processing units, until all of the first type messages of a codeword have been processed by the first type processing units, wherein the predetermined amount of the first type processing units is less than amount of the plurality of read first type messages; repeatedly reading a plurality of second type messages and feeding a part of the plurality of read second type messages to a predetermined amount of second type processing units, until all of the second type messages of the codeword have been processed by the second type processing units, wherein the predetermined amount of the second type processing units is less than amount of the plurality of read second type messages. The first memory unit is coupled to the access controlling module and utilized for storing a plurality of initial values of the codeword. The second memory unit is coupled to the access controlling module and utilized for storing the first type messages and the second type messages. The counter module is coupled to the processing module, and utilized for updating an iteration counter value.

In the following, the invention is further illustrated by way of example, taking reference to the accompanying drawings. Thereof

Fig. 1 shows a simplified block diagram of a decoder for decoding LDPC codes according to a first embodiment of the present invention;
Fig. 2 is a flow chart showing an exemplary method for decoding LDPC codes according to the first embodiment of the present invention;

Certain terms are used throughout the following description and claims to refer to particular decoder components. As one skilled in the art will appreciate, manufacturers may refer to a component by different names. This document does not intend to distinguish between components that differ in name but not function. In the following discussion and in the claims, the terms "include", "including", "comprise", and "comprising" are used in an open-ended fashion, and thus should be interpreted to mean "including, but not limited to ..." The terms "couple" and "coupled" are intended to mean either an indirect or a direct electrical connection. Thus, if a first device couples to a second device, that connection may be through a direct electrical connection, or through an indirect electrical connection via other devices and connections.

Low density parity check (LDPC) codes are well represented by bipartite graphs, often called Tanner graphs, in which one set of nodes, the bit nodes, corresponds to bits of the codeword and the other set of nodes, the check nodes, corresponds to the set of parity-check checking which binary value, "0" or "1", defines the codeword. Edges in the graph connect bit nodes to check nodes. A bit node and a check node are said to be neighbors if they are connected by an edge in the graph. For simplicity, we generally assume that a pair of nodes is connected by at most one edge. Each bit node is associated with one bit of the codeword. The decoders and decoding algorithms used to decode LDPC codeword operate by exchanging messages within the graph along the edges and updating these messages by performing computations at the nodes based on the incoming messages.

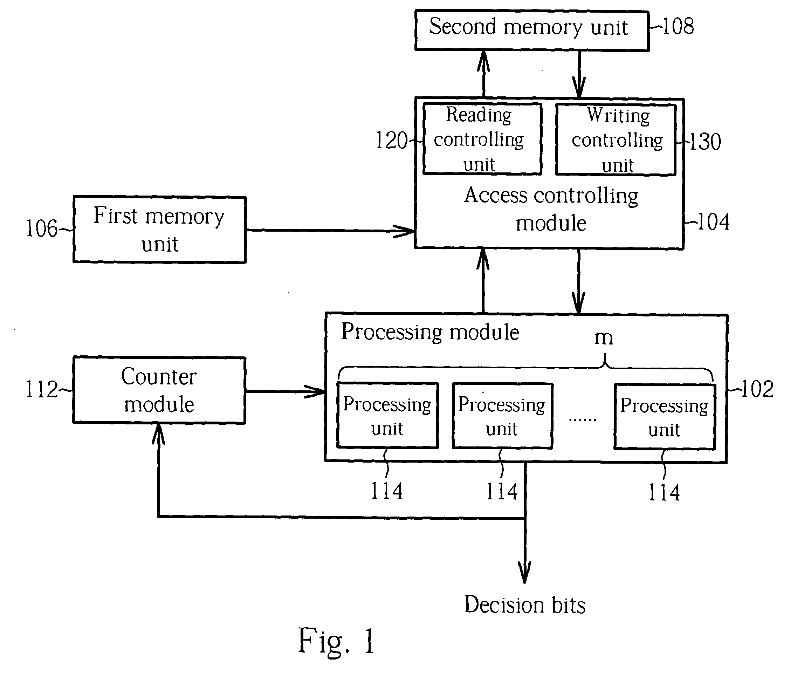

Please refer to Fig. 1. Fig. 1 shows a simplified block diagram of a decoder 100 for decoding LDPC codes according to a first embodiment of the present invention. As shown in Fig. 1, the decoder 100 includes a processing module 102, an access controlling module 104, a first memory unit 106, a second memory unit 108, and a counter module 112, wherein the processing module 102 includes a predetermined amount m of processing units 114. It should be noted that only the components pertinent to the present invention are shown in Fig. 1. That is, the configuration shown in Fig. 1 is for illustrative purpose only.

When the decoder 100 is utilized to decode a codeword, a memory word having a number n of messages is read from the second memory unit 108 and a number m out of the n message are fed to the m processing units 114, the predetermined amount m can be less than the number n, for example, m can be half of n, but it is not a limitation of the present invention. It is an option that a memory word can be further split into a plurality of sub-words so that only the sub-words that contain the m messages needed by the current computation of the processing unit 114 are read. For a clear description, in the following paragraphs, this term "first type message" will be utilized to represent any message from the check nodes to the bit nodes, and this term "second type message" will be utilized to represent any message from the bit nodes to the check nodes.

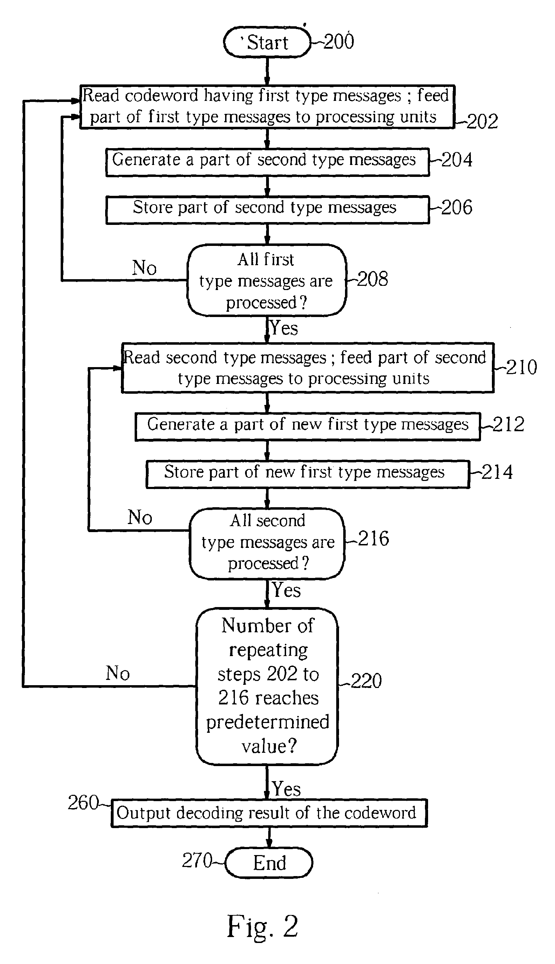

Please refer to Fig. 2. Fig. 2 is a flow chart showing an exemplary method for decoding LDPC codes according to the first embodiment of the present invention. Provided that substantially the same result is achieved, the steps of the flow need not be in the exact order shown and need not be contiguous, that is, other steps can be intermediate. In this exemplary embodiment, the decoding flow for LDPC codes comprises the following steps:

Step 200: Start.

Step 202: The access controlling module 104 reads a plurality of initial values from the first memory unit 106 or a plurality of first type messages from the second memory unit 108 and feeds a part of the initial value or the first type messages to the processing units 114.

Step 204: The processing units 114 generate a part of second type messages.

Step 206: The access controlling module 104 stores the part of second type messages in the second memory unit 108.

Step 208: Determine whether all of the first type messages of the codeword are completely processed. If all of the first type messages are processed, then go to step 210, and if not all of the first type messages are processed, then go back to step 202 to keep processing the remaining first type messages.

Step 210: The access controlling module 104 reads a plurality of second type messages from the second memory unit 108 and feeds a part of the second type messages to the processing units 114.

Step 212: The processing units 114 generate a part of new first type messages.

Step 214: The access controlling module 104 stores the part of new first type messages in the second memory unit 108.

Step 216: Determine whether all of the second type messages of the codeword are completely processed. If all of the second type messages are processed, then go to step 220, and if not all of the second type messages are processed, then go back to step 210.

Step 220: Determine whether a total number of repeating the steps 202, 204, 206, 208, Step 220: Determine whether a total number of repeating the steps 202, 204, 206, 208, 210, 212, 214, and 216 reaches a predetermined maximum iteration counter value counted by the counter module 112. If the total number of repeating the steps 202, 204, 206, 208, 210, 212, 214, and 216 does not reach the predetermined maximum iteration counter value counted by the counter module 112, then go to step 202, and if the total number of repeating the steps 202, 204, 206, 208, 210, 212, 214, and 216 reaches the predetermined maximum iteration counter value counted by the counter module 112, then go to step 260.

Step 260: The processing module 102 generates a decision result including a plurality of decision bits and output the decision result as a decoding result of the codeword.

Step 270: End.

As shown in Fig. 2 and taking m=180 and n=360 for a further illustration, first, the access controlling module 104 reads 360 initial values from the first memory unit 106 or 360 first type messages from the second memory unit 108 and feeds 180 first type messages to the processing units 114 in step 202; next, when all the initial values and first type message for the current 180 nodes are read, the processing units 114 generates 180 second type messages in step 204, and then the access controlling module 104 stores the 180 second type messages in the second memory unit 108 in step 206. Next, the decoder 100 determines whether all of the first type messages of the codeword are completely processed in step 208, and if not all of the first type messages are processed, the flow goes back to step 202 in order to let the access controlling module 104 feed remnant 180 first type messages to the processing units 114; and if all of the first type messages of the codeword are processed, the flow proceeds with step 210. In addition, it is alternative that the 180 first type messages can shuffled before the processing units 114 generates the 180 second type messages in step 204, or the 180 second type messages can be shuffled after the processing units 114 generates the 180 second type messages in step 204, in order to send the message to the processing unit that need the message. The operational details related to shuffling and storing the first type messages and the second type messages are well known to those of average skill in this art, and therefore further explanation is omitted herein for the sake of brevity.

Next, the access controlling module 104 reads 180 second type messages from the second memory unit 108 and feeds these 180 second type messages to the processing units 114 in step 210; next, when all the second type message for the current 180 nodes are read, the processing units 114 generate 180 new first type messages step 212, and then the access controlling module 104 stores the 180 new first type messages in the second memory unit 108 in step 214; next, the decoder 100 determines whether all of the second type messages of the codeword are completely processed in step 216, if all of the second type messages are processed, the flow goes to step 220, and if not all of the second type messages are processed, the flow goes back to step 210 in order to let the access controlling module 104 feed remnant 180 second type messages to the processing units 114; next, the processing units 114 generates another 180 new first type messages in step 212, and then the access controlling module 104 stores these 180 new first type messages in the second memory unit 108 in step 214. In addition, it is alternative that the 180 second type messages can shuffled before the processing units 114 generates the 180 new first type messages in step 212, or the 180 new first type messages can be shuffled after the processing units 114 generates the 180 new first type messages in step 212, in order to send the message to the processing unit that need the message The operational details related to shuffling and storing the new first type messages and the second type messages are well known to those of average skill in this art, and therefore further explanation is omitted herein for the sake of brevity.

Please note that the access controlling unit 104 can further includes a reading controlling unit 120 and a writing controlling unit 130 in the first embodiment, wherein the reading controlling unit 120 can be utilized for reading the first type messages and the second type messages, and the writing controlling unit 130 can be utilized for storing the first type messages and the second type messages. However, the operational details related to reading and storing the first type messages and the second type messages are well known to those of average skill in this art, and therefore further explanation is omitted herein for the sake of brevity.

Next, the flow goes to step 220 to determine whether a total number of repeating the steps 202, 204, 206, 208, 210, 212, 214, and 216 reaches a predetermined maximum iteration counter value, such as 50, counted by the counter module 112. Please note that the predetermined maximum iteration counter value can be adjusted according to different design requirements for the decoder 100. If the total number of repeating the steps 202, 204, 206, 208, 210, 212, 214, and 216 does not reach the predetermined maximum iteration counter value counted by the counter module 112, then the flow goes back to the step 202.

If the total number of repeating the steps 202, 204, 206, 208, 210, 212, 214, and 216, does reach the predetermined maximum iteration counter value counted by the counter module 112, then go to step 260, the processing module 102 generates a decision result including a pluraty of decision bits and output the decision result as a decoding result of the codeword,

Briefly summarized, the present invention LDPC decoder and decoding method does not require a large amount of the processing units 114 while the conventional LDPC decoder and decoding method does, and therefore the present invention LDPC decoder and decoding method is capable of attaining higher efficiency with lower cost.

## Claims

1.  A method for decoding LDPC codes, the method comprising:

    (a) repeatedly reading a plurality of first type messages and feeding a part of the plurality of read first type messages to a predetermined amount of first type processing units (114), until all of the first type messages of a codeword have been processed by the first type processing units (114), wherein the predetermined amount of the first type processing units (114) is less than amount of the plurality of read first type messages; and

(b) repeatedly reading a plurality of second type messages and feeding a part of the plurality of read second type messages to a predetermined amount of second type processing units (114), until all of the second type messages of the codeword have been processed by the second type processing units (114), wherein the predetermined amount of the second type processing units (114) is less than amount of the plurality of read second type messages.

2. The method of claim 1, **characterized in that** the step of repeatedly reading the plurality of first type messages further comprises splitting a memory word into a plurality of sub-words, and only the sub-words that contain the first type messages needed for a current computation of the first type processing units are read.

3. The method of claim 1, **characterized in that** the step of repeatedly reading the plurality of second type messages further comprises splitting a memory word into a plurality of sub-words, and only the sub-words that contain the second type messages needed for a current computation of the second type processing units are read.

4. The method of claims 1 or 2 or 3, **characterized in that** the second type processing units (114) and the first type processing units (114) are merged.

5. The method of claims 1 or 2 or 3, **characterized in that** the codeword complies with a DVB-S2 specification.

6. A decoder (100) for decoding LDPC codes, the decoder (100) comprising:

a processing module (102), comprising a predetermined amount of first type processing units (114) and a predetermined amount of second type processing units (114), for processing a plurality of first type messages and a plurality of second type messages and generating a decision result, wherein the decision result has a plurality of decision bits;
an access controlling module (104), coupled to the processing module (102), for repeatedly reading a plurality of first type messages and feeding a part of the plurality of read first type messages to a predetermined amount of first type processing units (114), until all of the first type messages of a codeword have been processed by the first type processing units (114), wherein the predetermined amount of the first type processing units (114) is less than amount of the plurality of read first type messages; repeatedly reading a plurality of second type messages and feeding a part of the plurality of read second type messages to a predetermined amount of second type processing units (114), until all of the second type messages of the codeword have been processed by the second type processing units (114), wherein the predetermined amount of the second type processing units (114) is less than amount of the plurality of read second type messages;
a first memory unit (106), coupled to the access controlling module (104), for storing a plurality of initial values of the codeword; and
a second memory unit (108), coupled to the access controlling module (104), for storing the first type messages and the second type messages.

7. The decoder (100) of claim 6, **characterized in that** the second type processing units (114) and the first type processing units (114) are merged

8. The decoder (100) of claim 6, **characterized in that** the access controlling module (104) further comprises a reading controlling unit (120) and a writing controlling unit (130).

9. The decoder of claim 6, **characterized in that** each word in the second memory unit is further split into a plurality of sub-words, and only the sub-words that contain the first type messages needed for a current computation of the first type processing units are read and the sub-words that contain the second type messages needed for a current computation of the second type processing units are read.

10. The decoder (100) of claims 6 or 9, **characterized in that** the codeword complies with a DVB-S2 specification.

**Amended claims in accordance with Rule 137(2) EPC.**

1. A method for decoding LDPC codes, the method comprising:

splitting a memory word into a plurality of sub-words;
repeatedly reading only the sub-words that contain a plurality of first type messages needed for a current computation of the first type processing units (114);
feeding a part of the plurality of read first type messages to a predetermined amount of first type processing units (114), until all of the first type messages of a codeword have been processed by the first type processing units (114), wherein the predetermined amount of the first type processing units (114) is less than amount of the plurality of read first type messages; repeatedly reading only the sub-words that contain the second type messages needed for a current computation of the second type processing units (114); and feeding a part of the plurality of read second type messages to a predetermined amount of second type processing units (114), until all of the second type messages of the codeword have been processed by the second type processing units (114), wherein the predetermined amount of the second type processing units (114) is less than amount of the plurality of read second type messages.

**2.** The method of claim 1, **characterized in that** the second type processing units (114) and the first type processing units (114) are merged.

**3.** The method of claim 1, **characterized in that** the method is for decoding LDPC codes according to a DVB-S2 LDPC matrix, and the codeword complies with a DVB-S2 specification.

**4.** A decoder (100) for decoding LDPC codes, the decoder (100) comprising:

a processing module (102), comprising a predetermined amount of first type processing units (114) and a predetermined amount of second type processing units (114), for processing a plurality of first type messages and a plurality of second type messages and generating a decision result, wherein the decision result has a plurality of decision bits;
a second memory unit (108), coupled to the access controlling module (104), for storing memory words comprising a plurality of first type messages and a plurality of second type messages, wherein each memory word is further split into a plurality of sub-words;
an access controlling module (104), coupled to the processing module (102), for repeatedly reading only the sub-words that contain the first type messages needed for a current computation of the first type processing units (114) and feeding a part of the plurality of read first type messages to a predetermined amount of first type processing units (114), until all of the first type messages of a codeword have been processed by the first type processing units (114), wherein the predetermined amount of the first type processing units (114) is less than amount of the plurality of read first type messages; repeatedly reading only the sub-words that contain the second type messages needed for a current computation of the second type processing units (114) and feeding a part of the plurality of read second type messages to a predetermined amount of second type processing units (114), until all of the second type messages of the codeword have been processed by the second type processing units (114), wherein the predetermined amount of the second type processing units (114) is less than amount of the plurality of read second type messages; and
a first memory unit (106), coupled to the access controlling module (104), for storing a plurality of initial values of the codeword.

**5.** The decoder (100) of claim 4, **characterized in that** the second type processing units (114) and the first type processing units (114) are merged

**6.** The decoder (100) of claim 4, **characterized in that** the access controlling module (104) further comprises a reading controlling unit (120) and a writing controlling unit (130).

**7.** The decoder (100) of claim 4, **characterized in that** the decoder (100) is for decoding LDPC codes according to a DVB-S2 LDPC matrix, and the codeword complies with a DVB-S2 specification.

Second memory unit —108

Reading controlling unit
120

Writing controlling unit
130

Access controlling module
104

First memory unit
106

Processing module

m

Counter module
112

Processing unit

Processing unit

......

Processing unit
102

114          114          114

Decision bits

Fig. 1

Start —200

Read codeword having first type messages ; feed
part of first type messages to processing units —202

Generate a part of second type messages —204

Store part of second type messages —206

All first
type messages are —208
processed ?

No

Yes

Read second type messages ; feed part of second
type messages to processing units —210

Generate a part of new first type messages —212

Store part of new first type messages —214

All second
type messages are —216
processed ?

No

Yes

Number of
repeating
steps 202 to
216 reaches —220
predetermined
value?

No

Yes

260— Output decoding result of the codeword

270— End

Fig. 2

**European Patent Office**

## EUROPEAN SEARCH REPORT

Application Number

EP 07 01 4700

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ZHANG T ET AL: "An FPGA implementation of (3,6)-regular low-density parity-check code decoder" EURASIP JOURNAL OF APPLIED SIGNAL PROCESSING, HINDAWI PUBLISHING CO., CUYAHOGA FALLS, OH, US, vol. 14, no. 2, June 2003 (2003-06), pages 530-542, XP002329888 ISSN: 1110-8657 * page 530 - page 531 * * page 534, column 1, line 11 - line 35 * * page 534, column 2, line 17 - line 20 * * figures 3-5 * ----- | 1-10 | INV. H03M13/11 |
| X | EP 1 729 423 A (TOKYO SHIBAURA ELECTRIC CO [JP]) 6 December 2006 (2006-12-06) * paragraph [0022] * * paragraph [0024] - paragraph [0025] * ----- | 1-10 | |
| X | YANNI CHEN ET AL: "A FPGA and ASIC implementation of rate 1/2, 8088-b irregular low density parity check decoder" GLOBECOM'03. 2003 - IEEE GLOBAL TELECOMMUNICATIONS CONFERENCE. CONFERENCE PROCEEDINGS. SAN FRANCISCO, DEC. 1 - 5, 2003, IEEE GLOBAL TELECOMMUNICATIONS CONFERENCE, NEW YORK, NY : IEEE, US, vol. VOL. 7 OF 7, 1 December 2003 (2003-12-01), pages 113-117, XP010677856 ISBN: 0-7803-7974-8 * the whole document * * page 114 * ----- -/-- | 1-10 | TECHNICAL FIELDS SEARCHED (IPC) H03M |

The present search report has been drawn up for all claims

| Place of search | Date of completion of the search | Examiner |
|---|---|---|
| The Hague | 21 September 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent
Office

**EUROPEAN SEARCH REPORT**

Application Number

EP 07 01 4700

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | NING CHEN, YONGMEI DAI, AND ZHIYUAN YAN: "Partly Parallel Overlapped Sum-Product Decoder Architectures for Quasi-Cyclic LDPC Codes" INTERNET ARTICL, [Online] 28 May 2006 (2006-05-28), XP002451993 Retrieved from the Internet: URL:http://www.ece.lehigh.edu/~yan/documents/CDYSiPSsubmitted.pdf> [retrieved on 2007-09-21] * the whole document * ----- | 1-10 | |
| X | YUPING ZHANG ET AL: "Efficient high-speed quasi-cyclic LDPC decoder architecture" SIGNALS, SYSTEMS AND COMPUTERS, 2004. CONFERENCE RECORD OF THE THIRTY-EIGHTH ASILOMAR CONFERENCE ON PACIFIC GROVE, CA, USA NOV. 7-10, 2004, PISCATAWAY, NJ, USA,IEEE, 7 November 2004 (2004-11-07), pages 540-544, XP010780360 ISBN: 0-7803-8622-1 * the whole document * ----- | 1-10 | TECHNICAL FIELDS SEARCHED (IPC) |
| X | YONGMEI DAI AND ZHIYUAN YAN: "Optimal overlapped message passing decoding for quasi-cyclic LDPC codes" INTERNET ARTICLE, [Online] 17 September 2005 (2005-09-17), XP002451998 Retrieved from the Internet: URL:http://www.ece.lehigh.edu/~yan/documents/DYTVLSIsubmitted.pdf> [retrieved on 2007-09-21] * figures 3,4 * * the whole document * ----- | 1-10 | |

-/--

The present search report has been drawn up for all claims

| Place of search | Date of completion of the search | Examiner |
|---|---|---|
| The Hague | 21 September 2007 | Rydyger, Kay |

EPO FORM 1503 03.82 (P04C01)

European Patent
Office

**EUROPEAN SEARCH REPORT**

Application Number

EP 07 01 4700

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | MANSOUR M M ET AL: "Turbo decoder architectures for low-density parity-check codes" GLOBECOM'02. 2002 - IEEE GLOBAL TELECOMMUNICATIONS CONFERENCE. CONFERENCE PROCEEDINGS. TAIPEI, TAIWAN, NOV. 17 - 21, 2002, IEEE GLOBAL TELECOMMUNICATIONS CONFERENCE, NEW YORK, NY : IEEE, US, vol. VOL. 1 OF 3, 17 November 2002 (2002-11-17), pages 1383-1388, XP010636372 ISBN: 0-7803-7632-3 * figure 1 * ----- | 1-10 | |

| | | | TECHNICAL FIELDS SEARCHED (IPC) |
|---|---|---|---|

The present search report has been drawn up for all claims

| Place of search | Date of completion of the search | Examiner |
|---|---|---|
| The Hague | 21 September 2007 | Rydyger, Kay |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**                  EP 07 01 4700

This annex lists the patent family members relating to the patent documents cited in the above-mentioned European search report.
The members are as contained in the European Patent Office EDP file on
The European Patent Office is in no way liable for these particulars which are merely given for the purpose of information.

21-09-2007

| Patent document cited in search report | | Publication date | Patent family member(s) | | Publication date |
|---|---|---|---|---|---|
| EP 1729423 | A | 06-12-2006 | CN | 1874165 A | 06-12-2006 |
| | | | JP | 2006339799 A | 14-12-2006 |
| | | | KR | 20060125501 A | 06-12-2006 |
| | | | US | 2006271616 A1 | 30-11-2006 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20050283703 A1

- US 20040005865 A1